# EUROPEAN PATENT SPECIFICATION

(11) **EP 2 309 022 B1**
(45) Date of publication and mention of the grant of the patent: **31.10.2018**
(21) Application number: 10176369.6
(22) Date of filing: 13.09.2010
(51) Int. Cl.: C23C 16/34, C23C 16/52

(54) **Gas barrier coating and gas barrier film**
Gassperrbeschichtung und Gassperrschicht
Revêtement de barrière à gaz et film barrière à gaz

(30) Priority: 17.09.2009 JP 2009215785
(43) Date of publication of application: 13.04.2011
(73) Proprietor: Fujifilm Corporation, Minato-ku Tokyo (JP)
(72) Inventor: Takahashi, Toshiya, Kanagawa (JP); Senga, Takeshi, Kanagawa (JP); Tonohara, Kouji, Kanagawa (JP)
(74) Representative: Hoffmann Eitle

(56) References cited:
- WO-A1-2010/023987
- JP-A- 2004 292 877
- JP-A- 2005 342 975
- US-A1- 2008 211 066
- US-A1- 2009 110 896
- DAVID M. HOFFMANN AND SRI PRAKASH RANGARAJAN, SATISCH D: ATHAVALE AND DEMETRE J. ECONOMOU, JIA-RUI LIU, ZONGSHUANG ZHENG AND WEI-K: "Plasma-enhanced chmeical vapor deposition of silicon, germanium, and tin nitride thin film form metalorganic precursors" J. VAC. SCI. TECHNOL. A, vol. 13, no. 3, 1 May 1995 (1995-05-01), pages 820-825, XP002608606
- Q. XU, Y. RA, M. BACHMAN, G. P. LI: "Characterization of low-temeprature silicon nitride films produced by inductively coupled plasma chemical vapor deposition" J. VAC. SCI. TECHNOL. A, vol. 27, no. 1, 1 January 2009 (2009-01-01), pages 145-156, XP002608607
- V. VERLAAN, A.D. VERKERK, W.M. ARNOLDBIK, CH.M. VAN DER WERF, R.BAKKER, Z.S. HOUWELING, I.G. ROMIJN, D.M.BORSA, A.W. WEEBER, S.L.: "The effect of composition on the bond structure and refractive index of silicon nitride deposited by HWCVD and PECVD" THIN SOLID FILMS, vol. 517, 27 January 2009 (2009-01-27), pages 3499-3502, XP002608608

## Description

### BACKGROUND OF THE INVENTION

The present invention relates to gas barrier coatings and gas barrier films for use in displays and so forth, and particularly to gas barrier coatings excellent not only in gas barrier property but oxidation resistance, transparency and flexibility, and gas barrier films including such gas barrier coatings.

A gas barrier coating (water-vapor barrier coating) is formed on parts or elements to be made moisture proof of a variety of devices including an optical device, a display such as liquid crystal display or organic EL display, a semiconductor device and a thin-film solar cell, or formed in packaging materials used to package food, clothing, electronic components, or the like. A gas barrier film with a gas barrier coating formed (deposited) on a support (substrate) such as a resin film also has such applications.

Known gas barrier coatings include those composed of silicon oxide, silicon oxynitride, and aluminum oxide. As an example of known gas barrier coatings, a gas barrier coating based on silicon nitride is also mentioned.

Gas barrier coatings (gas barrier films) are required to have various properties in accordance with their uses, namely, a high light-transmitting property (transparency), a high resistance to oxidation, and so forth, as well as a good gas barrier property.

Accordingly, for a gas barrier coating composed of silicon nitride also, many proposals have been made to impart required properties to the coating.

For instance, JP 2004-292877 A discloses the gas barrier coating (silicon nitride coating) whose composition is expressed as SiNₓ, with x being 1.05 to 1.33, and whose refractive index at a wavelength of 633 nm is 1.8 to 1.96. The coating preferably has the peak associated with the N-H bond that occurs in the vicinity of 3350 cm⁻¹ and/or 1175 cm⁻¹ in a Fourier transform infrared absorption spectrum (hereafter referred to as "FTIR spectrum") of the coating, whereupon the ratio of the peak intensity at 3350 cm⁻¹ to the peak intensity in the vicinity of 840 cm⁻¹ associated with the Si-N bond is 0.04 or more.

The document states that the gas barrier coating, as having such characteristics as above, is excellent not only in gas barrier property but transparency and adhesion, and a rapid deposition thereof is possible even at lower temperatures.

JP 2005-342975 A discloses a transparent barrier film comprising a silicon nitride coating with a N/Si compositional ratio of 0.8 to 1.4 and a density of 2.1 to 3.0 g/cm³.

It is stated in the document that the transparent barrier film as such can yield a gas barrier film having a good oxygen/water-vapor barrier property and, at the same time, a high transparency.

Finally, JP 2008-214677 A describes a gas barrier coating formed of two or more silicon nitride layers having different Si/N compositional ratios. The gas barrier coating preferably includes a layer with a Si/N compositional ratio of not more than 1.4 and a layer 50 nm or less thick with a Si/N compositional ratio of more than 1.4, and is preferably formed by laminating two or more silicon nitride layers which are different from one another in A/B and A/C, with A denoting the peak intensity in the vicinity of 3350 cm⁻¹ in a FTIR spectrum that is attributable to the N-H stretching vibration, B denoting the peak intensity in the vicinity of 860 cm⁻¹ attributable to the Si-N stretching vibration, and C denoting the peak intensity in the vicinity of 2160 cm⁻¹ attributable to the Si-H stretching vibration.

The document states that the gas barrier coating as above is highly resistant to oxidation, and exhibits a high transparency
US 2009/110896 discloses a gas barrier coating based on silicon nitride, having a N/Si compositional ratio of 1.1 to 1.3, and a hydrogen content of 10 to 30 atomic percent, and a peak of an absorption caused by Si-H stretching vibration occurs at a wavenumber near 2150 cm -1 in a Fourier transform infrared absorption spectrum of the coating, with a ratio I(Si-H) /I(Si-N) between a peak intensity I(Si-H) of the absorption caused by Si-H stretching vibration and a peak intensity I(Si-N) of an absorption caused by Si-N stretching vibration in the vicinity of 810 cm-1 being approx. 0.12.

### SUMMARY OF THE INVENTION

As described in the above documents, a gas barrier coating based on silicon nitride can be made to have a high transparency or oxidation resistance as well as a good gas barrier property by specifying the compositional ratio of silicon to nitrogen or vice versa, the N-H bonding state, the Si-N bonding state, the Si-H bonding state, and so forth.

In recent years, however, gas barrier coatings are required more and more severely to offer a good performance with respect to various properties, so that the gas barrier coating is awaited which has not only a better gas barrier property but higher transparency and oxidation resistance, or even a high flexibility.

An object of the present invention is to solve the above problems with the prior art so as to provide a gas barrier coating excellent not only in gas barrier property but transparency and oxidation resistance, and flexibility as well. It is another object of the present invention to provide a gas barrier film including such a gas barrier coating.

In order to achieve the objects, the present invention provides a gas barrier coating according to claim 1.

In the gas barrier coating of the present invention as above, the ratio [I_{(N-H)}/I_{(Si-N)}] between a peak intensity I_{(N-H)} of an absorption caused by N-H stretching vibration in the vicinity of 3350 cm⁻¹ in the Fourier transform infrared absorption spectrum and the peak intensity I_{(Si-N)} is preferably 0.03 to 0.07. The density of the coating is preferably 2.1 to 2.7 g/cm³. The ratio [I_{(N-H})/I_{(Si}-_{H)}] between a peak intensity I_{(N-H)} of an absorption caused by N-H stretching vibration in the vicinity of 3350 cm⁻¹ in the Fourier transform infrared absorption spectrum and the peak intensity I_{(Si-KH)} is 0.5 to 1.5. Ii is preferable that a peak of the absorption caused by Si-N stretching vibration in the vicinity of 840 cm⁻¹ occurs at a wavenumber ranging from 820 to 860 cm⁻¹ in the Fourier transform infrared absorption spectrum. The mean Si-N bond length is preferably 1.69 to 1.73 Å. Preferably, the gas barrier coating of the invention has an oxygen content of not more than 15 atomic percent and a thickness of 10 to 150 nm.

The present invention also provides a gas barrier film comprising a resin film with a glass transition temperature of 130°C or lower, and the gas barrier coating of the present invention deposited on the resin film.

In an embodiment of the present invention, the gas barrier coating has a visible light transmittance of not less than 95% as a single layer.

In another embodiment of the present invention, the gas barrier film comprises a substrate film and the gas barrier coating of the present invention deposited on the substrate film, wherein the gas barrier film has a gas barrier property permitting a gas permeation of at most 1 × 10⁻⁵ [g/(m²·day)], and a visible light transmittance of not less than 85%, and wherein the gas barrier property and the visible light transmittance are maintained even after the film is left in an environment at a temperature of 60°C and a relative humidity of 90% for 1000 hours, and even after the film is wound into a roll 10 mm in diameter, then unwound 1000 times, as well. In yet another embodiment, the gas barrier film comprises a substrate film and the gas barrier coating of the present invention deposited on the substrate film, wherein the gas barrier film has a gas barrier property permitting a gas permeation of at most 3 × 10⁻³ [g/(m²·day)], and a visible light transmittance of not less than 85%, and wherein the gas barrier property and the visible light transmittance are maintained even after the film is left in an environment at a temperature of 85°C and a relative humidity of 90% for 1000 hours, and even after the film is wound into a roll 10 mm in diameter, then unwound 1000 times, as well.

According to the present invention whose configuration is described above, a gas barrier coating excellent not only in gas barrier property but transparency, oxidation resistance and flexibility, and a gas barrier film using such a gas barrier coating can be obtained.

The present invention is therefore suitably applicable to various cases where a gas barrier coating with high transparency and resistance to oxidation as well as a good gas barrier property is needed, such as the manufacture of displays or lighting fixtures utilizing organic electroluminescence or liquid crystal, and the manufacture of solar cells.

### BRIEF DESCRIPTION OF THE DRAWINGS

FIG. 1 is a schematic diagram showing an example of the gas barrier film of the invention using the gas barrier coating of the invention;
FIG. 2 is a diagram showing an exemplary Fourier transform infrared absorption spectrum of a gas barrier coating based on silicon nitride;
FIG. 3 is a schematic diagram showing another example of the gas barrier film of the invention using the gas barrier coating of the invention;
FIG. 4A is a diagram showing exemplary Fourier transform infrared absorption spectra of the gas barrier coating of Example 1;
FIG. 4B is a diagram showing exemplary Fourier transform infrared absorption spectra of the gas barrier coating of Comparative Example 1; and
FIG. 5 is a graph showing the relationship between the N/Si compositional ratio and the visible light transmittance of a gas barrier coating based on silicon nitride.

### DETAILED DESCRIPTION OF THE INVENTION

The following description is made in order to illustrate the gas barrier coating and gas barrier film according to the present invention in reference to the preferred embodiments as shown in the attached drawings.

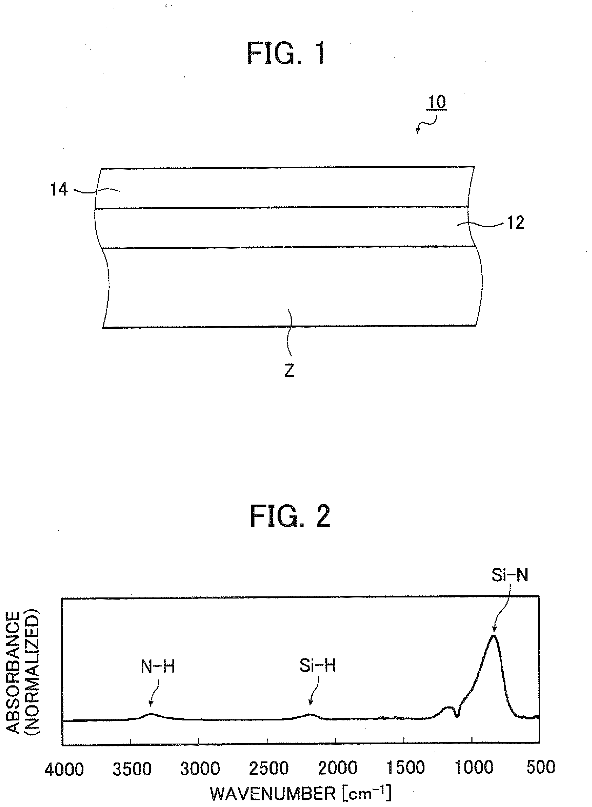

FIG. 1 schematically shows an example of the gas barrier film of the invention using the gas barrier coating of the invention.

A gas barrier film 10 shown in FIG. 1 has an organic layer 12 on the surface of a substrate Z, and an inorganic layer 14 as the gas barrier coating of the invention, which is formed on the organic layer 12.

The substrate Z in the gas barrier film 10 of the invention is not particularly limited, and various types of known substrates used for the deposition of a gas barrier coating, including various sheetlike articles and optical elements such as lenses and filters, are usable.

Suitable examples of the substrate Z include resin films (plastic films) made of various resin materials, such as polyethylene terephthalate (PET), polyethylene naphthalate, polyethylene, polypropylene, polystyrene, polyamide, polyvinyl chloride, polycarbonate, polyacrylonitrile, polyimide, polyacrylate, and polymethacrylate.

Among others, a resin film having a glass transition temperature of 130°C or lower is preferred as the substrate Z.

Gas barrier coatings based on silicon nitride are often deposited by a vapor deposition technique such as plasma CVD.

As is well-known, during the vapor deposition of a conventional coating based on silicon nitride, higher deposition temperatures are advantageous in terms of oxidation resistance, gas barrier property, and so forth. If, however, a film of less heat-resistant resin such as PET is used as the substrate Z, a possible damage to the substrate Z prevents the deposition at as high a substrate temperature as 150°C.

In contrast, the gas barrier coating of the invention is excellent not only in gas barrier property but transparency and has a very high resistance to oxidation even if deposited at a lower substrate temperature of 130°C or less. In other words, according to the present invention, a gas barrier film having a gas barrier coating excellent in gas barrier property, transparency ((visible) light-transmitting property), oxidation resistance, and so forth can be obtained with no damage to the film of less heat-resistant resin such as PET used as the substrate Z by carrying out low-temperature deposition at a temperature of 130°C or less.

If a resin film having a glass transition temperature of 130°C or lower is used as the substrate Z, the present invention, which is effective in that a gas barrier coating with excellent properties is obtained by low-temperature deposition even if the substrate Z is less heat-resistant, is applied more suitably and achieves more desirable results.

In addition, according to the present invention, a gas barrier coating excellent not only in gas barrier property but transparency and oxidation resistance can be deposited at an even lower substrate temperature of 75°C or less. Consequently, the present invention as above is applied more suitably and achieves more desirable results even in the case where a resin film with a lower glass transition temperature of 75°C or less is used as the substrate Z.

The thickness of the substrate Z is not particularly limited, while a thickness of 10 to 150 µm is preferable. A thickness of 10 to 150 µm is preferred especially when a resin film with a glass transition temperature of 130°C or lower is used as the substrate Z.

If the thickness of the substrate Z is less than 10 µm, the mechanical strength of the gas barrier film may not be adequate depending on the type of the substrate Z. On the other hand, while a gas barrier coating having a high transparency is obtained according to the present invention even if low-temperature deposition is performed using a resin film with a glass transition temperature of 130°C or lower as the substrate, the transparency of the substrate Z with a thickness of more than 150 µm may have a predominant influence on the total transparency of the gas barrier film and, in that case, the gas barrier film may not be adequately transparent in spite of a high transparency of the gas barrier coating. The substrate of larger thickness than 150 µm is also disadvantageous in terms of flexibility and so forth. In addition, it is unfavorable to increase the thickness of the substrate Z more than necessary because gas barrier films for organic EL displays or liquid crystal displays are required to have ever reduced thickness and weight. The above thickness range for the substrate is suitable for reducing the gas barrier film in thickness and weight without impairing an adequate strength thereof.

In view of the above as a whole, a desirable thickness of the substrate Z is 25 to 100 µm.

The substrate Z may also be a resin film, lens or the like as a support having various functional layers (coatings) formed thereon, such as a protective layer, an adhesive layer, a light-reflecting layer, a lightproof layer, a cushioning layer, and a stress-relaxing layer.

In that case, the functional layers formed may be one or more in number.

In the preferred embodiment as shown in FIG. 1, the gas barrier film 10 has the organic layer 12 deposited on the surface of the substrate Z, and the inorganic layer 14, which is the gas barrier coating of the invention, is deposited on the layer 12.

According to the present invention, an organic layer provided as an undercoat for the inorganic layer 14 (gas barrier coating of the invention) covers up the surface asperities of the substrate Z to prepare a flat surface for the deposition of the inorganic layer 14. As a consequence, the inorganic layer 14, namely the gas barrier coating of the invention, fully exhibits its excellent properties, and the gas barrier film 10 is made more excellent not only in gas barrier property but transparency, oxidation resistance, or even in flexibility.

The constituent material for (or, the chief component of) the organic layer 12 is not particularly limited, and various known organic substances (organic compounds) are usable, with preferable examples thereof including among others a variety of resins (organic polymer compounds).

Exemplary resins include an epoxy resin, an acrylic resin, a methacrylic resin, polyester, a methacrylic acid - maleic acid copolymer, polystyrene, a transparent, fluorinated resin, polyimide, fluorinated polyimide, polyamide, polyamide-imide, polyether imide, cellulose acylate, polyurethane, polyether ketone, polycarbonate, fluorene ring-modified polycarbonate, alicyclic-modified polycarbonate, and fluorene ring-modified polyester.

Preferably, the organic layer 12 is a layer composed of an organic substance with a glass transition temperature of 150°C or higher.

As described later, the gas barrier coating of the invention (inorganic layer 14) is preferably deposited by plasma CVD. Plasma CVD may roughen the surface for deposition, especially when the material on which deposition is performed has a lower glass transition temperature. A roughened surface for deposition is unfavorable because the effects brought about by providing the organic layer 12 are diminished.

The organic layer 12 composed of an organic substance with a glass transition temperature of 150°C or higher will adequately prevent the surface for deposition from being roughened during the deposition of the gas barrier coating by plasma CVD, leading to a more stable deposition of the gas barrier coating which is excellent not only in gas barrier property but transparency, oxidation resistance, or even in flexibility.

It is preferable in view of the above that the organic layer 12 is based on an acrylic resin, methacrylic resin or the like.

The method of depositing (forming) the organic layer 12 is not particularly limited, and any known method of depositing an organic substance may be used.

Exemplary methods include the method by application in which an organic substance or organic monomer, a polymerization initiator, and additional ingredients, if any, are dissolved (dispersed) in a solvent to prepare a coating formulation, and the coating formulation is applied onto the substrate Z using a known means of application, such as a roll coater, a gravure coater and a spray coater, then dried, and cured as required by heating, UV irradiation, electron beam irradiation, or the like. The method by flash evaporation is also suitable for use in which an organic substance or such a coating formulation as prepared in the above method by application is evaporated, and the vapor thus generated is deposited onto the substrate Z and cooled/condensed to form a liquid film, which is cured using an ultraviolet radiation or an electron beam so as to complete the deposition. In addition, the method by transfer is usable in which the organic layer 12 is formed as a separate sheet before being transferred onto the substrate Z.

The thickness of the organic layer 12 is not particularly limited but may be specified as appropriate to the surface properties or thickness of the substrate Z, the gas barrier property required, and so forth, while a thickness of 0.3 to 5 µm is preferable.

The organic layer 12 having a thickness within the above range ensures such desirable results that the surface asperities of the substrate Z are covered up without fail to suitably prepare a flat surface for the deposition of the inorganic layer 14, the roughening of the surface for deposition during the formation of the inorganic layer 14 by, for instance, plasma CVD is decreased, and that an improved adhesion is achieved.

The organic layer 12 is not limited in structure either, but may be formed of one or more coatings of organic substances.

For instance, the organic layer 12 may be formed of two organic coatings, whereupon one coating is deposited by flash evaporation on the other coating deposited by application.

In the gas barrier film 10, the inorganic layer 14 is deposited on the organic layer 12.

The inorganic layer 14 is the gas barrier coating of the invention, so that it is based on silicon nitride, and has a N/Si (nitrogen/silicon) compositional ratio of 1 to 1.4 and a hydrogen content of 10 to 30 atomic percent (at.%). In the inorganic layer 14, a peak of the absorption caused by the Si-H stretching vibration occurs at a wavenumber ranging from 2170 to 2200 cm⁻¹ in a Fourier transform infrared absorption spectrum (FTIR spectrum), with the ratio [I_{(Si-H)}/I_{(Si-N)}] between the peak intensity I_{(Si-H)} of the absorption caused by the Si-H stretching vibration and the peak intensity I_{(Si-N)} of the absorption caused by the Si-N stretching vibration in the vicinity of 840 cm⁻¹ being 0.03 to 0.15.

Owing to its configuration as above, the present invention has effected a gas barrier coating excellent not only in gas barrier property but transparency (light-transmitting property), oxidation resistance (weatherability at high temperatures/humidities (environmental resistance)), or even in flexibility, and a gas barrier film having such a gas barrier coating.

A coating based on silicon nitride is used as a gas barrier coating in various displays, semiconductor devices, and packaging materials.

In accordance with their uses, gas barrier coatings are required to have a high transparency, a high resistance to oxidation (high environmental resistance) or the like, as well as a good gas barrier property. In order to fulfill such requirement, it has been proposed that a gas barrier coating having more excellent properties be provided by specifying not only the compositional ratio of silicon to nitrogen or vice versa but the FTIR absorption spectrum.

For instance, it is described in JP 2004-292877 A as referred to before that the cracking of a silicon nitride coating as well as the coloring thereof is inhibited by defining x in SiNₓ, the chemical formula of the silicon nitride constituting the coating, to be 1.05 to 1.33, causing a peak associated with the N-H bond to occur in the vicinity of 3350 cm⁻¹ and/or 1175 cm⁻¹ in a FTIR spectrum, and further defining the ratio of the peak intensity at 3350 cm⁻¹ to the peak intensity in the vicinity of 840 cm⁻¹ associated with the Si-N bond to be 0.04 or more, which secures a desired gas barrier property.

In JP 2008-214677 A as also referred to before, it is described that a silicon nitride coating is not only excellent in gas barrier property but has an improved resistance to oxidation even if formed by low-temperature deposition when the coating comprises two or more silicon nitride layers having different Si/N compositional ratios, which layers are different from one another in A/B and A/C, with A denoting the peak intensity in the vicinity of 3350 cm⁻¹ in a FTIR spectrum that is attributable to the N-H stretching vibration, B denoting the peak intensity in the vicinity of 860 cm⁻¹ attributable to the Si-N stretching vibration, and C denoting the peak intensity in the vicinity of 2160 cm⁻¹ attributable to the Si-H stretching vibration, and especially when the coating comprises a layer having a Si/N compositional ratio of not more than 1.4, an A/B value of not more than 0.08, and an A/C value of not more than 0.3.

As seen from the above, previous studies on the improvement of not only the gas barrier property but the transparency and the oxidation resistance of silicon nitride coatings as a gas barrier coating are conducted focusing attention on the relationship between the peak intensities in a FTIR spectrum associated with the N-H bond and with the Si-N bond, respectively, or the relationship between the peak intensities associated with the N-H bond and with the Si-H bond, respectively, as well as the compositional ratio of silicon to nitrogen or vice versa.

In contrast, the present invention focuses attention on the absorption caused by the Si-H stretching vibration, of which a peak occurs at a wavenumber ranging from 2170 to 2200 cm⁻¹ in a FTIR spectrum, and the absorption caused by the Si-N stretching vibration in the vicinity of 840 cm⁻¹, to be more specific, on the peak intensities of these absorptions, rather than the absorption associated with the N-H bond, so as to obtain more stably the gas barrier coating which is excellent in gas barrier property, transparency, oxidation resistance, and in flexibility as well.

A peak of the absorption caused by the Si-H stretching vibration is critical to the oxidation resistance and the transparency in particular. It is also critical to the gas barrier property because an oxidized coating is considerably deteriorated in gas barrier property. Specifically, according to the researches conducted by the inventors of the present invention, the position (expressed as a wavenumber) of a peak of the absorption caused by the Si-H stretching vibration chiefly correlates with the transparency and the oxidation resistance, and the correlation therebetween is much more delicate in comparison to the case of the N-H stretching vibration. Among the pieces of information obtained from a FTIR spectrum, the ratio [I_{(Si-H)}/I_{Si-N)}] between the peak intensity I_{(Si-H)} of the absorption caused by the Si-H stretching vibration and the peak intensity I_{(Si-N)} of the absorption caused by the Si-N stretching vibration in the vicinity of 840 cm⁻¹ has the strongest correlation with the oxidation resistance. Moreover, investigations on the oxidation of a coating based on silicon nitride revealed that the cleavage of N-H bonds is not indispensable to the oxidation, whereas the cleavage of Si-H and Si-N bonds is necessary for the bonding of oxygen atoms.

The above can indicate that it is optimal for the attainment of stable gas barrier property, transparency and resistance to oxidation to focus attention on peaks of the absorption caused by the Si-H stretching vibration and the absorption caused by the Si-N stretching vibration. A gas barrier coating excellent in gas barrier property, transparency, oxidation resistance, and in flexibility as well will be obtained even more stably by taking account of the composition and hydrogen content of the coating in addition to the characteristics of the peaks.

As described before, the inorganic layer 14 as the gas barrier coating of the invention is a coating based on silicon nitride (hereafter also referred to as "silicon nitride coating" for convenience' sake), and has a N/Si compositional ratio of 1 to 1.4.

N/Si compositional ratios smaller than 1 are disadvantageous because they may cause the inorganic layer 14 to be colored and thereby fail to have an adequate transparency.

N/Si compositional ratios larger than 1.4 are also disadvantageous for their own reasons that an adequate resistance to oxidation is not achieved, an adequate gas barrier property is not secured over a long period of time, and that the inorganic layer 14 is made liable to cracking.

In view of the above, a more preferable N/Si compositional ratio is 1.2 to 1.35.

In the present invention, with respect to the silicon nitride coating as the inorganic layer 14 or the inventive gas barrier coating, the hydrogen content thereof is taken into consideration apart from the compositional ratio of nitrogen to silicon and peaks in the FTIR spectrum. According to the present invention, the inorganic layer 14 has a hydrogen content of 10 to 30 atomic percent.

The inorganic layer 14 having a hydrogen content higher than 30 atomic percent is disadvantageous for such reasons that an adequate resistance to oxidation is not achieved, an adequate gas barrier property is not secured over a long period of time, and that the inorganic layer 14 is made liable to cracking.

In fact, hydrogen atoms in a silicon nitride coating are originated from a gaseous raw material or the like, and their inclusion is inevitable. A lower hydrogen content is more preferable as a characteristic of a gas barrier coating, whereupon a content of not more than 5 atomic percent is particularly preferred, with the ideal being 0 atomic percent. Reduction in hydrogen content, however, requires a special treatment or operation (e.g., a considerable elevation of the substrate temperature during deposition, or a post-annealing treatment), and higher production costs. Moreover, it is well thinkable that a hydrogen-free coating has a poor flexibility because bonds in the coating are very firmly linked together in a three-dimensional manner. Favorable productivity and costs as well as an adequate flexibility can be secured by allowing the inorganic layer 14 to have a hydrogen content of not less than 10 atomic percent.

Preferably, the inorganic layer 14 is made to have a hydrogen content of 15 to 25 atomic percent because the layer 14 as such avoids the above disadvantageousness more conveniently.

In the inorganic layer 14 of the invention, a peak of the absorption caused by the Si-H stretching vibration occurs at a wavenumber within the range of 2170 to 2200 cm⁻¹ in the FTIR spectrum of the layer 14.

FIG. 2 shows an exemplary FTIR spectrum of a silicon nitride coating. As seen from FIG. 2, and from FIG. 11 of JP 2004-292877 A as well, the absorption caused by the Si-H stretching vibration is represented in the FTIR spectrum of silicon nitride by a broad peak in the region of 2000 to 2300 cm⁻¹.

As long as the coating is appropriately formed, and spectral measurement, correction of measurements, and so forth are properly performed, a peak of the above absorption will occur at a wavenumber of not more than 2200 cm⁻¹, whereupon a higher wavenumber is more preferable, that is to say, the coating is more liable to oxidation with a lower wavenumber as a peak position. According to the researches conducted by the inventors of the present invention, a peak occurring at a wavenumber of less than 2170 cm⁻¹ is disadvantageous for such reasons that an adequate resistance to oxidation is not achieved, and that an adequate gas barrier property is not secured over a long period of time.

Since a peak of the absorption caused by the Si-H stretching vibration generally occurs at a wavenumber of not more than 2200 cm⁻¹, a peak at a wavenumber higher than 2200 cm⁻¹ may suggest such inconveniences as errors due to the instrument used, correction errors, and an inappropriate deposition of a coating.

In the FTIR spectrum of silicon nitride, the absorption caused by the Si-H stretching vibration is represented by a broad peak in the region of 2000 to 2300 cm⁻¹ as mentioned above, and the absorption caused by the Si-N stretching vibration is represented by a broad peak in the vicinity of 840 cm⁻¹, which is also seen from FIG. 2.

As described before, the present invention focuses attention on the absorption caused by the Si-H stretching vibration, of which a peak occurs at a wavenumber ranging from 2170 to 2200 cm⁻¹ in the FTIR spectrum, and the absorption caused by the Si-N stretching vibration in the vicinity of 840 cm⁻¹ rather than the absorption associated with the N-H bond, and, according to the present invention, the ratio [I_{(Si}-_{H)}/I_{(Si-N)}] between the peak intensity I_{(Si-H)} of the absorption caused by the Si-H stretching vibration and the peak intensity I_{(Si-N)} of the absorption caused by the Si-N stretching vibration in the vicinity of 840 cm⁻¹ is 0.03 to 0.15.

Peak intensity ratios [I_{(Si-H)}/I_{(Si-N)}] outside the above range, whether smaller than 0.03 or larger than 0.15, are disadvantageous for such reasons that an adequate resistance to oxidation is not achieved, an adequate gas barrier property is not secured over a long period of time, and that an adequate flexibility is hard to attain.

The inorganic layer 14 suitably has a peak intensity ratio [I_{(Si-H)}/I_{(Si-N)}] of 0.03 to 0.15, a ratio conveniently avoiding the above disadvantageousness.

It is further seen from FIG. 2 that the absorption caused by the N-H stretching vibration is represented in the FTIR spectrum of a silicon nitride coating by a broad peak in the vicinity of 3350 cm⁻¹.

In the inorganic layer 14 of the invention, the ratio [I_{(N-H)}/I_{(Si-H)}] between the peak intensity I_{(H-H)} of the absorption caused by the N-H stretching vibration in the vicinity of 3350 cm⁻¹ in the FTIR spectrum and the peak intensity I_{(Si-N)} of the absorption caused by the Si-N stretching vibration in the vicinity of 840 cm⁻¹ is preferably 0.03 to 0.07.

A peak intensity ratio [I_{(N-H)}/I_{(Si-N)}] of not less than 0.03 is advantageous in that coloring of the coating is prevented more conveniently to allow the inorganic layer 14 having a high transparency, and that the adhesion to the substrate Z or the underlying layer (undercoat) is improved. On the other hand, a peak intensity ratio [I_{(N-H)}/I_{(Si-N)}] of not more than 0.07 is advantageous in that a higher resistance to oxidation is achieved, an adequate gas barrier property is secured over a long period of time, the adhesion to the substrate Z or the underlying layer is improved, and that an adequate flexibility is easier to attain.

In terms of a more convenient acquisition of the above advantages, it is more preferable that the inorganic layer 14 has a peak intensity ratio [I_{(N-H)}/I_{(Si-N)}] of 0.03 to 0.06.

The density of the inorganic layer 14 is not particularly limited, with a density of 2.1 to 2.7 g/cm³ being preferable.

A density of not less than 2.1 g/cm³ is advantageous in that a higher resistance to oxidation is achieved, an adequate gas barrier property is secured over a long period of time, and that the adhesion to the substrate Z or the underlying layer is improved. While a coating with a higher density is more liable to cracking, a density of not more than 2.7 g/cm³ is advantageous in that cracking due to a higher density is suitably prevented (improvement in flexibility), and that the adhesion to the substrate Z or the underlying layer is improved.

In terms of a more convenient acquisition of the above advantages, it is more preferable that the inorganic layer 14 has a density of 2.3 to 2.6 g/cm³.

In the inorganic layer 14 of the invention, the ratio [I_{(N-H)}/I_{(Si}-_{H)}] between the peak intensity I_{(N-H)} of the absorption caused by the N-H stretching vibration in the vicinity of 3350 cm⁻¹ in the FTIR spectrum and the peak intensity I_{(Si-H)} of the absorption caused by the Si-H stretching vibration, of which a peak occurs at a wavenumber ranging from 2170 to 2200 cm⁻¹, is 0.5 to 1.5.

A peak intensity ratio [I_{(N-H)}/I_{(Si-H)}] of not less than 0.5 is advantageous in that coloring of the coating is prevented conveniently to allow the inorganic layer 14 having a high transparency. On the other hand, a peak intensity ratio [I_{(N-H})/I_{(Si-H)}] of not more than 1.5 is advantageous in that a higher resistance to oxidation is achieved, and that an adequate gas barrier property is secured over a long period of time.

In terms of a more convenient acquisition of the above advantages, a peak intensity ratio [I_{(N-H)}/I_{(Si-H)}] of 0.7 to 1.3 is more preferable.

In the inorganic layer 14 of the invention, a peak of the absorption caused by the Si-N stretching vibration in the vicinity of 840 cm⁻¹ in the FTIR spectrum preferably occurs at a wavenumber within the range of 820 to 860 cm⁻¹.

A peak at a wavenumber of not less than 820 cm⁻¹ is advantageous in that coloring of the coating is prevented conveniently to allow the inorganic layer 14 having a high transparency. On the other hand, a peak at a wavenumber of not more than 860 cm⁻¹ is advantageous in that a higher resistance to oxidation is achieved, an adequate gas barrier property is secured over a long period of time, and that the adhesion to the substrate Z or the underlying layer is improved.

In terms of a more convenient acquisition of the above advantages, it is more preferable that a peak of the absorption caused by the Si-N stretching vibration in the vicinity of 840 cm⁻¹ occurs at a wavenumber within the range of 825 to 845 cm⁻¹.

In the present invention, the silicon nitride on which the inorganic layer 14 is based preferably has a mean Si-N bond length of 1.69 to 1.73 Å.

Mean Si-N bond lengths within the above range are advantageous in that a higher resistance to oxidation is achieved, an adequate gas barrier property is secured over a long period of time, the adhesion to the substrate Z or the underlying layer is improved, and that coloring of the coating is prevented conveniently to allow the inorganic layer 14 having a high transparency.

Preferably, the inorganic layer 14 has an oxygen content of not more than 15 atomic percent.

Oxygen atoms in the inorganic layer 14 are the impurities whose inclusion is inevitable depending on the deposition conditions or the like, and an oxygen content of not more than 15 atomic percent is advantageous in that a higher gas barrier property is achieved, and that cracking due to the internal structure of the coating is suitably prevented (improvement in flexibility).

In terms of a more convenient acquisition of the above advantages, it is more preferable that the content of oxygen atoms in the inorganic layer 14 is 10% or lower.

The thickness of the inorganic layer 14 is not particularly limited but may be specified as appropriate to the gas barrier property required, and so forth, while a thickness of 10 to 150 nm is preferable.

An adequate gas barrier property is achieved stably by allowing the inorganic layer 14 to have a thickness of not less than 10 nm. While the inorganic layer 14 basically has a better gas barrier property as it increases in thickness, the gas barrier property will be hard to further improve if the inorganic layer 14 has a thickness of more than 150 nm. Conversely, a thickness of not more than 150 nm is advantageous in that cracking of the inorganic layer 14 is suitably prevented.

In terms of a more convenient acquisition of the above advantages, a more preferable thickness of the inorganic layer 14 is 20 to 80 nm.

The inorganic layer 14 (gas barrier coating of the invention) is excellent in transparency as described before, having a visible light transmittance (mean transmittance in the wavelength range of 400 to 700 nm) of, for instance, 95% or higher.

The inorganic layer 14 of the invention is excellent not only in gas barrier property and transparency but oxidation resistance, and flexibility as well.

Consequently, according to the present invention, a gas barrier film including the gas barrier coating based on silicon nitride which is deposited on a substrate film can be obtained as an optimal one for displays. In that case, the gas barrier film has a gas barrier property permitting a gas permeation of at most 1 × 10⁻⁵ [g/(m²·day)] and a visible light transmittance (as defined above) of 85% or higher, and maintains its gas barrier property and visible light transmittance even after being left in an environment at a temperature of 60°C and a relative humidity of 90% for 1000 hours, and even after being wound into a roll 10 mm in diameter, then unwound 1000 times, as well.

Also according to the present invention, a gas barrier film including the gas barrier coating based on silicon nitride which is deposited on a substrate film can be obtained as an optimal one for solar cells. This gas barrier film has a gas barrier property permitting a gas permeation of at most 3 × 10⁻³ [g/(m²·day)] and a visible light transmittance (as defined above) of 85% or higher, and maintains its gas barrier property and visible light transmittance even after being left in an environment at a temperature of 85°C and a relative humidity of 90% for 1000 hours, and even after being wound into a roll 10 mm in diameter, then unwound 1000 times, as well.

It is also possible according to the present invention to obtain a gas barrier film of even higher quality including the gas barrier coating based on silicon nitride which is deposited on a substrate film. The gas barrier film should have a gas barrier property permitting a gas permeation of at most 1 × 10⁻⁵ [g/(m²·day)] and a visible light transmittance (as defined above) of 85% or higher, and maintain its gas barrier property and visible light transmittance even after being left in an environment at a temperature of 85°C and a relative humidity of 85% for 1000 hours, and even after being wound into a roll 10 mm in diameter, then unwound 1000 times, as well.

As a matter of course, in any of the above gas barrier films, the visible light transmittance of the film in itself varies with that of the substrate film or a layer thereon.

Such gas barrier films as above are conveniently obtained particularly when they include the organic layer 12 as shown in FIG. 1 serving as an undercoat for the inorganic layer 14.

In the present invention, the method of depositing (forming) the inorganic layer 14 (gas barrier coating of the invention) is not particularly limited, and any known technique for the deposition of a silicon nitride coating, such as vacuum evaporation, sputtering, or chemical vapor deposition (CVD), is usable.

Among others, a variety of plasma CVD techniques including capacitively coupled plasma-enhanced CVD (CCP-CVD), inductively coupled plasma-enhanced CVD (ICP-CVD), microwave CVD, electron cyclotron resonance CVD (ECR-CVD) and atmospheric dielectric-barrier discharge CVD are suitable for use.

The inorganic layer 14 deposited by plasma CVD is advantageous in that a higher gas barrier property is achieved, cracking due to the internal structure of the coating is suitably prevented (improvement in flexibility), and that the productivity is enhanced.

The gaseous raw materials to be used to deposit the inorganic layer 14, namely the gas barrier coating of the invention, by plasma CVD are not particularly limited but may be selected appropriately from the gaseous raw materials for use in the deposition of a silicon nitride coating by a conventional plasma CVD technique, as exemplified by silane gas, disilane gas, tetraethoxysilane (TEOS), hexamethyl disiloxane (HMDSO), hexamethyl disilazane (HMDSN), tetramethylsilane (TMS), hydrazine gas, ammonia gas, nitrogen gas, hydrogen gas, argon gas, neon gas, and helium gas. In addition, deposition conditions may basically be specified as appropriate to the gaseous raw materials to be used, the thickness of the inorganic layer 14 to be deposited, and so forth.

The gas barrier coating of the invention, and preferred embodiments of the gas barrier coating of the invention, can be realized by controlling during the deposition by plasma CVD such conditions as the amounts and proportions of the reactive gases fed, the deposition pressure, the plasma-exciting electric power, the plasma-exciting frequency, the electric power for biasing, the substrate temperature (within a range acceptable to the less heat-resistant film as a substrate, if used), the pressure to be attained before deposition, and the distance between the substrate and the plasma-generating area appropriately so as to control the N/Si compositional ratio, the peak positions and peak intensities of individual absorptions in the FTIR spectrum, the hydrogen content, the oxygen content, the mean Si-N bond length, and so forth.

The peak positions and peak intensities of individual absorptions in the FTIR spectrum are influenced by all the deposition conditions as above, which have effects on one another. Accordingly, the solution to the specification of deposition conditions for the gas barrier coating of the invention is not limited to one, that is to say, various deposition conditions may be discussed to specify/establish them as appropriate to individual apparatus. It could be argued that a practical use of a silicon nitride coating deposited at a low temperature for a transparent gas barrier film is an important object of the present invention, so that it is preferable to control the proportions of the reactive gases fed, the deposition pressure, the plasma-exciting electric power or the like to thereby modify the N/Si compositional ratio, the peak positions and peak intensities of individual absorptions in the FTIR spectrum, and so forth as aimed.

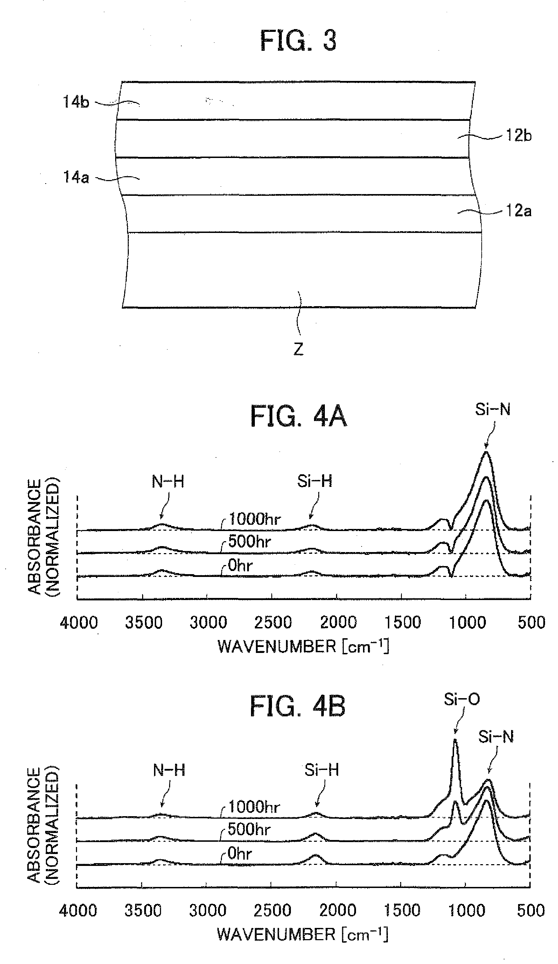

The gas barrier film 10 of the invention as shown in FIG. 1 has one organic layer 12 and one inorganic layer 14 on the substrate Z, although the present invention is not limited to such a structure. In the gas barrier film according to the present invention, the organic layer 12 and the inorganic layer 14 may each be two or more in number and, in that case, the layers 12 and the layers 14 may be stacked alternately. In other words, the gas barrier film of the invention may have a laminated structure including two or more combinations of the organic layer 12 and the inorganic layer 14, such as the structure as schematically shown in FIG. 3 which includes an organic layer 12a, an inorganic layer 14a, an organic layer 12b, and an inorganic layer 14b sequentially deposited on the substrate Z.

A structure including two or more organic layers 12 and two or more inorganic layers 14, with the layers 12 and the layers 14 being stacked alternately, achieves more desirable results in terms of the gas barrier property.

While the organic layer 12 and the inorganic layer 14 are preferably both two or more in number, it is also possible that either the layer 12 or the layer 14 is two or more in number. If both are to be made two or more in number, the number of organic layers 12 and the number of inorganic layers 14 may differ from each other.

In view of surface protection, the organic layer 12 may be arranged uppermost in the stack of layers, with such arrangement being preferable particularly when the organic layer 12 is made two or more in number.

A multilayer structure including two or more organic layers 12 and two or more inorganic layers 14 makes it possible to obtain the gas barrier film which is more excellent in gas barrier property, mechanical strength, oxidation resistance, ability to maintain its gas barrier property over a long period of time, light extraction efficiency, and other properties.

In the case where the gas barrier film of the invention includes a plurality of inorganic layers 14, every layer 14 does not need to be the gas barrier coating of the invention as long as at least one layer 14 is the gas barrier coating of the invention. In other words, out of the inorganic layers 14, one or more may each be the gas barrier coating of the invention and the rest may each be a silicon oxide or aluminum oxide coating.

It, however, is preferable that, in the gas barrier film of the invention including a plurality of inorganic layers 14, two or more layers 14, all the layers 14 in particular, are each the gas barrier coating of the invention.

The gas barrier coating and gas barrier film according to the present invention have thus been described in detail, while the present invention is in no way limited to the above embodiments. As a matter of course, various improvements or modifications can be made without departing from the gist of the invention.

### EXAMPLES

### [Example 1]

Using a common CVD apparatus for depositing a coating by a CCP-CVD technique, a gas barrier coating was formed on a substrate.

The substrate used was a 100 µm-thick PET film (Lumirror^{(R)} T60 manufactured by Toray Industries, Inc.; the total luminous transmittance, 89%).

Silane (SiH₄) gas, ammonia (NH₃) gas, nitrogen (N₂) gas, and hydrogen (H₂) gas were used as gaseous raw materials.

The electric power supply used was a radio-frequency power supply operating at a frequency of 13.56 MHz.

The substrate was mounted on a substrate holder in a vacuum chamber of the CVD apparatus before the chamber was closed. The air in the chamber was sucked out to allow a pressure of 0.1 Pa inside the chamber, then the gaseous raw materials were introduced into the chamber at flow rates of 80 sccm for the silane gas, 150 sccm for the ammonia gas, 200 sccm for the nitrogen gas, and of 170 sccm for the hydrogen gas.

After the pressure in the chamber was stabilized at 50 Pa, a plasma-exciting power of 1300 W was fed from the RF power supply to electrodes to deposit a gas barrier coating based on silicon nitride on the surface of the substrate, so as to produce a gas barrier film including the gas barrier coating based on silicon nitride that was deposited on the PET film as a substrate.

The gas barrier coating was so deposited as to have a thickness of 50 nm. The thickness of the coating was controlled based on preliminary experiments. During the deposition, the substrate temperature was adjusted to 70°C or lower by a temperature-adjusting means built in the substrate holder.

With respect to the gas barrier film as produced, the N/Si compositional ratio and hydrogen content of the gas barrier coating were measured on a backscattering spectrometer (type AN 2500 manufactured by NHV Corporation) by means of Rutherford backscattering analysis and hydrogen forward scattering analysis.

It was found that the coating had a N/Si compositional ratio of 1.36 and a hydrogen content of 23 atomic percent.

The gas barrier coating was subjected to FTIR spectroscopy, and it was found that a peak attributable to the Si-H stretching vibration occurred at 2184.5 cm⁻¹.

The peak intensity ratio [I_{(Si-H)}/I_{(Si-N)}] as determined from the peak intensity I_{(Si-H)} of the peak attributable to the Si-H stretching vibration and the peak intensity I_{(Si-N)} of a peak attributable to the Si-N stretching vibration in the vicinity of 840 cm⁻¹ was 0.048 (see FIG. 4A).

In this Example, the gas barrier coating which was absolutely equivalent to that deposited on the PET substrate was deposited on a Si wafer ((001) face) as a substrate, and subjected to transmission FTIR spectroscopy. It was confirmed that the measurements had the same tendency as those obtained upon the ATR-FTIR spectroscopy of the gas barrier coating in the above gas barrier film using the PET substrate.

FTIR-spectroscopic results of a gas barrier coating on a Si wafer substrate are actually more precise than those of a gas barrier coating in such a gas barrier film as above. For this reason, the position of a peak attributable to the Si-H stretching vibration, and the peak intensity ratio [I_{(Si-H)}/I_{(Si-N)}] as well, in the FTIR spectrum of the gas barrier coating in the above gas barrier film were obtained by the transmission FTIR spectroscopy of an equivalent gas barrier coating formed on a Si wafer substrate.

### [Comparative Example 1]

A gas barrier film was produced by following the procedure in Example 1 except that the raw material flow rate was 60 sccm for the ammonia gas, 400 sccm for the nitrogen gas and 60 sccm for the hydrogen gas, the deposition pressure was 100 Pa, and the plasma-exciting power was 600 W.

With respect to the gas barrier coating in the gas barrier film as produced, the N/Si compositional ratio, the hydrogen content, the position of a peak attributable to the Si-H stretching vibration, and the peak intensity ratio [I_{(Si-H)}/I_{(Si-N)}] were determined in the same manner as Example 1.

It was found that the gas barrier coating had a N/Si compositional ratio of 0.97 and a hydrogen content of 33.6 atomic percent, a peak attributable to the Si-H stretching vibration occurred at 2157.2 cm⁻¹, and that the peak intensity ratio [I_{(Si-H)}/I_{(Si-N)}] was 0.17.

The gas barrier coatings in the gas barrier films as produced in Example 1 and Comparative Example 1, respectively, were subjected to FTIR spectroscopy immediately after the production, after being left in an environment at a temperature of 85°C and a relative humidity of 85% for 500 hours, and after being left in the environment at a temperature of 85°C and a relative humidity of 85% for 1000 hours.

The spectroscopic results are set forth in FIGs. 4A and 4B, with FIG. 4A showing the FTIR spectra of Example 1 and FIG. 4B showing those of Comparative Example 1.

In each of FIGs. 4A and 4B, the FTIR spectrum immediately after the production (shown with "0 hr"), that after 500 hours (shown with "500 hr"), and that after 1000 hours (shown with "1000 hr") are arranged in this order from below for a better visibility of the change over time, whereas the baselines of the three spectra each represented by a dotted horizontal line should be assumed to be located at one and the same absorbance level.

As seen from FIG. 4A, the inventive gas barrier coating of Example 1, in which the N/Si compositional ratio, the hydrogen content, the position of a peak attributable to the Si-H stretching vibration, and the peak intensity ratio [I_{(Si-H)}/I_{(Si-N)}] fell within their respective ranges as defined, did not change significantly in FTIR spectrum even after being left in the environment at a temperature of 85°C and a relative humidity of 85% for 500 or 1000 hours, that is to say, it was proved that the gas barrier coating of Example 1 was highly resistant to oxidation, and had a good gas barrier property over a long period of time.

In contrast, the gas barrier coating of Comparative Example 1, in which none of the N/Si compositional ratio, the hydrogen content, the position of a peak attributable to the Si-H stretching vibration and the peak intensity ratio [I_{(Si}-_{H)}/I_{(Si-N)}] fell within the range as defined, was left in the environment at a temperature of 85°C and a relative humidity of 85% for 500 hours, when the absorption caused by the Si-O stretching vibration, which had not been recognized immediately after the production, was recognized in the vicinity of 1080 cm⁻¹ in the FTIR spectrum, as shown in FIG. 4B. Moreover, the absorption was increased after the gas barrier coating was left in the above environment for 1000 hours, which demonstrated a progressed oxidation of the coating.

### [Examples 2 to 4 and Comparative Examples 2 to 4]

Six different gas barrier films, the films of Examples 2 to 4 and the films of Comparative Examples 2 to 4, were produced by following the procedure in Example 1 except that one ore more selected from the flow rate of individual reactive gases, the plasma-exciting electric power and the deposition pressure were modified as appropriate.

With respect to the gas barrier coatings in the gas barrier films as produced, the N/Si compositional ratio, the hydrogen content (at.%), the position (cm⁻¹) of a peak attributable to the Si-H stretching vibration, and the peak intensity ratio [I_{(Si-H)}/I_{(Si-N)}] were determined in the same manner as Example 1.

In addition, the ratio [I_{(N-H)}/I(_{Si-N)}] between the peak intensity I_{(N-H)} of the absorption caused by the N-H stretching vibration in the vicinity of 3350 cm⁻¹ and the peak intensity I_{(Si-N)}, as well as the ratio [I(_{N-H})/I_{(Si-H)}] between the peak intensity I_{(N-H)} and the peak intensity I_{(Si-H)} were determined from the FTIR-spectroscopic results.

For each gas barrier coating, the density (g/cm³) was measured on an X-ray diffractometer for thin film analysis (type ATX-E manufactured by Rigaku Corporation) by means of X-ray reflectivity measurement.

The results are set forth in Table 1.

**Table 1**

| | N/Si | Hydrogen content (at.%) | Si-H peak (cm⁻¹) | Si-H/Si-N | N-H/Si-N | N-H/Si-H | Density (g/cm³) |
|---|---|---|---|---|---|---|---|
| Ex. 2 | 1.24 | 26.0 | 2185.9 | 0.060 | 0.043 | 0.71 | 2.38 |
| Ex. 3 | 1.08 | 25.1 | 2177.2 | 0.071 | 0.037 | 0.52 | 2.40 |
| Ex. 4 | 1.39 | 24.5 | 2180.1 | 0.040 | 0.076 | 1.90 | 2.44 |
| Comp. Ex. 2 | 1.52 | 35.3 | 2171.6 | 0.032 | 0.118 | 3.69 | 2.32 |
| Comp. Ex. 3 | 1.05 | 37.4 | 2157.0 | 0.140 | 0.078 | 0.56 | 2.09 |
| Comp. Ex. 4 | 0.73 | 40.6 | 2140.0 | 0.300 | 0.080 | 0.27 | 1.90 |

The gas barrier films of Examples 2 to 4 and Comparative Examples 2 to 4 were examined in gas barrier property, visible light transmittance, and oxidation resistance.

### <Gas Barrier Property>

The gas barrier films were measured for water vapor transmission rate [g/(m²·day)] by MOCON method. If any sample had a water vapor transmission rate beyond the measurement limit of MOCON method, the sample was newly measured by the calcium corrosion method (as disclosed in JP 2005-283561 A).

### <Visible Light Transmittance>

Using a spectrophotometer (type U-4100 manufactured by Hitachi High-Technologies Corporation), each gas barrier film (inclusive of the PET substrate) was measured for mean transmittance in the wavelength range of 400 to 700 nm. The mean transmittance of the PET film as a substrate was also obtained.

The visible light transmittance (%) of the relevant gas barrier film was evaluated on the basis of the mean transmittance of the PET film as assumed to be 100%.

### <Oxidation Resistance>

The gas barrier films were evaluated for oxidation resistance by storing them in an environment at specified temperature and humidity (relative humidity (%)) for 1000 hours.

To be more specific: For each gas barrier film, the gas barrier coating in the relevant film was measured for composition by means of X-ray photoelectron spectroscopy (XPS; conducted on an XPS microprobe PHI Quantera SXM™ manufactured by ULVAC-PHI, Inc.) before and after the storage so as to determine the ratio of oxygen to nitrogen (O/N value) in the region from which a surface or interface having already been oxidized before the storage was excluded. If the O/N value after the storage was increased from that before the storage by at least 10%, the gas barrier film was considered "as oxidized." The evaluation for oxidation resistance was carried out on the basis of the oxidative environments in which the gas barrier film was stored. In other words:
the gas barrier film which was not oxidized after being stored in an environment at a temperature of 85°C and a humidity of 85% for 1000 hours was rated 5;
the gas barrier film which was not oxidized after being stored in an environment at a temperature of 60°C and a humidity of 90% for 1000 hours was rated 4;
the gas barrier film which was not oxidized after being stored in an environment at a temperature of 40°C and a humidity of 90% for 1000 hours was rated 3;
the gas barrier film which was not oxidized after being stored in an environment at a temperature of 25°C and a humidity of 50% for 1000 hours was rated 2; and
the gas barrier film which was oxidized after being stored in an environment at a temperature of 25°C and a humidity of 50% for 1000 hours was rated 1.

The results are set forth in Table 2.

**Table 2**

| | Gas barrier property [g/(m²·day)] | Visible light transmittance (%) | Oxidation resistance |
|---|---|---|---|
| Ex. 2 | 1.2E-03 | 99.1 | 5 |
| Ex. 3 | 1.1E-03 | 98.3 | 5 |
| Ex. 4 | 1.6E-03 | 99.0 | 4 |
| Comp. Ex. 2 | 2.6E-03 | 99.3 | 3 |
| Comp. Ex. 3 | 6.4E-03 | 96.7 | 2 |
| Comp. Ex. 4 | 7.7E-02 | 89.7 | 1 |

As seen from Table 2, the gas barrier films of Examples 2 to 4, in each of which the N/Si compositional ratio, the hydrogen content, the position of a peak attributable to the Si-H stretching vibration, and the peak intensity ratio [I_{(Si}-_{H)}/I_{(Si-N)}] fell within their respective ranges as defined, were excellent in any of gas barrier property, visible light transmittance, and oxidation resistance. The gas barrier films of Examples 2 and 3, whose gas barrier coatings each had preferable peak intensity ratios [I_{(N-H)}/I_{(Si-N)}] and [I_{(N-H)}/I_{(Si-H)}] as well as a preferable density, attained particularly desirable results.

In contrast, the gas barrier film of Comparative Example 2, in which the N/Si compositional ratio and the hydrogen content were beyond their respective ranges as defined, had a poor gas barrier property and a low resistance to oxidation. The gas barrier film of Comparative Example 3, in which the hydrogen content was high and the peak position associated with the Si-H bond was too low, as well as the gas barrier film of Comparative Example 4, in which the N/Si compositional ratio was small, the hydrogen content was high, the peak position associated with the Si-H bond was too low, and the peak intensity ratio [I_{(Si-H)}/I_{(Si-N)}] was large, were each inferior in any of gas barrier property, visible light transmittance, and oxidation resistance.

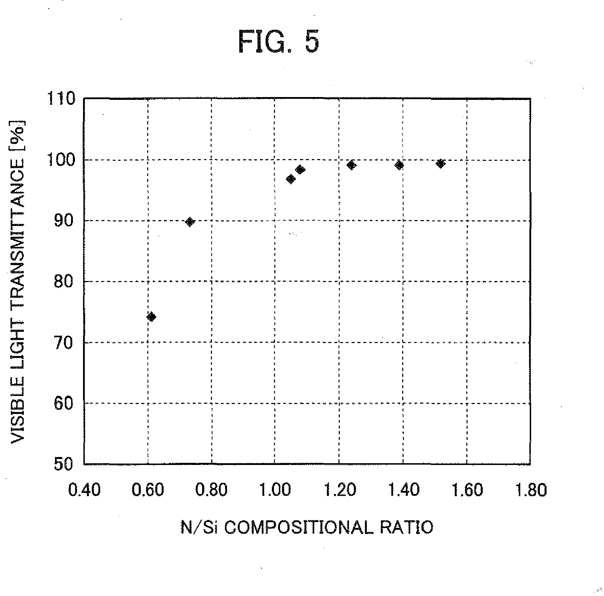

FIG. 5 shows the visible light transmittance of the gas barrier films produced in Examples 2 to 4 and Comparative Examples 2 to 4 as a function of N/Si compositional ratio.

As evident from FIG. 5, a gas barrier film is allowed to have a high visible light transmittance, namely a good transparency, by imparting a N/Si compositional ratio of not less than 1 to a gas barrier coating based on silicon nitride in the film.

### [Example 5]

An organic layer was deposited on the same substrate as Example 2 (that is to say, as Example 1), then a gas barrier coating was deposited on the organic layer under the same conditions as Example 2 so as to produce the gas barrier film as shown in FIG. 1 which has the organic layer 12 and the inorganic layer 14 deposited on the substrate Z.

In this Example, the organic layer 12 was the 500 nm-thick organic layer based on trimethylolpropane triacrylate (TMPTA) that was formed by preparing a coating formulation containing 1.37 g of TMPTA in monomer form (A-TMPT manufactured by Shin-Nakamura Chemical Co., Ltd.) and 0.134 g of a radical polymerization initiator (ESACURE^{(R)} KTO 46 manufactured by Lamberti S.p.A.) dissolved in 18.5 g of methyl ethyl ketone, applying the coating formulation with a roll coater, and drying, then UV-curing the coating formulation.

### [Example 6]

The deposition of the organic layer 12 and the gas barrier coating in Example 5 was performed twice so as to produce the gas barrier film as shown in FIG. 3 which has the organic layer 12a, the inorganic layer 14a, the organic layer 12b and the inorganic layer 14b deposited on the substrate Z.

The gas barrier films of Examples 5 and 6, along with the gas barrier film of Example 2, were measured for gas barrier property (water vapor transmission rate [g/(m²·day)]) in the same way as described above relating to Examples 2 to 4 and Comparative Examples 2 to 4. The measurement was conducted after the gas barrier films were stored at normal temperature and humidity for 1000 hours, after the films were stored in an environment at a temperature of 60°C and a relative humidity of 90% for 1000 hours, after the films were stored in an environment at a temperature of 85°C and a relative humidity of 80% for 1000 hours, and after the films were each wound onto a cylindrical rod 10 mm in diameter, then unwound 10000 times.

The results are set forth in Table 3.

**Table 3**

| | Layered structure | Gas barrier property | | | |
|---|---|---|---|---|---|
| | | Normal temp. and humidity | 60°C and 90% | 85°C and 85% | Winding on a ø10-mm rod |
| Ex. 2 | PET/SiN | 1.2E-03 | 1.1E-03 | 1.5E-03 | 1.4E-03 |
| Ex. 5 | PET/Organic/SiN | 2.5E-05 | 2.9E-05 | 2.2E-05 | 2.8E-05 |
| Ex. 6 | PET/Oorganic/SiN/ Oorganic/SiN | <1.0E-05 | <1.0E-05 | <1.0E-05 | <1.0E-05 |

The measurement limit was 1.0E-05 [g/(m²·day)].

It is evident from Table 3 that the gas barrier film of the invention is not decreased significantly in gas barrier property even if left standing in an environment at high temperature and humidity for a long period of time or wound onto a thin rod a huge number of times, that is to say, is very excellent in oxidation resistance (environmental resistance), and flexibility as well.

### INDUSTRIAL APPLICABILITY

The present invention is suitably applicable to the production of a variety of those products which need gas barrier coatings with high transparency and resistance to oxidation as well as a good gas barrier property, such as the production of various displays including liquid crystal displays or solar cells.

## Claims

1. A gas barrier coating based on silicon nitride, having a N/Si compositional ratio of 1 to 1.4 and
a hydrogen content of 10 to 30 atomic percent,
wherein:
a peak of an absorption caused by Si-H stretching vibration occurs at a wavenumber ranging from 2170 to 2200 cm⁻¹ in a Fourier transform infrared absorption spectrum of the coating, with
a ratio [I_{(Si-H)}/I_{(Si-N)}] between a peak intensity I_{(Si-H)} of the absorption caused by Si-H stretching vibration and a peak intensity I_{(Si-N)} of an absorption caused by Si-N stretching vibration in the vicinity of 840 cm⁻¹ being 0.03 to 0.15; and wherein
a ratio [I_{(N-H)}/I_{(Si-H)}] between a peak intensity I_{(N-H)} of an absorption caused by N-H stretching vibration in the vicinity of 3350 cm⁻¹ in the Fourier transform infrared absorption spectrum and said peak intensity I_{(Si-H)} is 0.5 to 1.5, wherein the coating is on a substrate.

2. The gas barrier coating according to claim 1, wherein
a ratio [I_{(N-H)}/I_{(Si-N)}] between a peak intensity I_{(N-H)} of an absorption caused by N-H stretching vibration in the vicinity of 3350 cm⁻¹ in the Fourier transform infrared absorption spectrum and said peak intensity I_{(Si-N)} is 0.03 to 0.07.

3. The gas barrier coating according to claim 1 or 2, having a density of 2.1 to 2.7 g/cm³.

4. The gas barrier coating according to any one of claims 1 to 3, wherein a peak of the absorption caused by Si-N stretching vibration in the vicinity of 840 cm⁻¹ occurs at a wavenumber ranging from 820 to 860 cm⁻¹ in the Fourier transform infrared absorption spectrum.

5. The gas barrier coating according to any one of claims 1 to 4, wherein a mean Si-N bond length is 1.69 to 1.73 Å.

6. The gas barrier coating according to any one of claims 1 to 5, having an oxygen content of not more than 15 atomic percent.

7. The gas barrier coating according to any one of claims 1 to 6, having a thickness of 10 to 150 nm.

8. The gas barrier coating according to any one of claims 1 to 7, having a visible light transmittance of not less than 95% as a single layer.

9. A gas barrier film comprising:
a resin film with a glass transition temperature of 130 °C or lower; and
the gas barrier coating according to any one of claims 1 to 8 deposited on the resin film.

10. A gas barrier film comprising:
a substrate film; and
the gas barrier coating according to any one of claims 1 to 9 deposited on the substrate film,
wherein the gas barrier film has a gas barrier property permitting a gas permeation of at most 1 * 10⁻⁵ [g/(m²·day)], and a visible light transmittance of not less than 85%, and
wherein the gas barrier property and the visible light transmittance are maintained even after being left in an environment at a temperature of 60 °C and a relative humidity of 90% for 1000 hours, and even after being wound into a roll 10 mm in diameter, then unwound 1000 times, as well.

11. A gas barrier film comprising:
a substrate film; and
the gas barrier coating according to any one of claims 1 to 9 deposited on the substrate film,
wherein the gas barrier film has a gas barrier property permitting a gas permeation of at most 3 * 10⁻³ [g/(m²·day)], and a visible light transmittance of not less than 85%, and
wherein the gas barrier property and the visible light transmittance are maintained even after being left in an environment at a temperature of 85 °C and a relative humidity of 90% for 1000 hours, and even after being wound into a roll 10 mm in diameter, then unwound 1000 times, as well.

## Patentansprüche

1. Gassperrbeschichtung, basierend auf Siliciumnitrid, mit einem N/Si-Zusammensetzungsverhältnis von 1 bis 1,4 und einem Wasserstoffgehalt von 10 bis 30 Atom%, worin:
ein Absorptionspeak, der durch eine Si-H-Streckschwingung verursacht wird, bei einer Wellenzahl im Bereich von 2.170 bis 2.200 cm⁻¹ in einem FT-IR-Absorptionsspektrum der Beschichtung auftritt, wobei
ein Verhältnis [I_{(Si-H)}/I_{(Si-N)}] zwischen der Peakintensität I_{(Si-H)} der Absorption, die durch die Si-H-Streckschwindung verursacht wird, und der Peakintensität I_{(Si-N)} einer Absorption, die durch eine Si-N-Streckschwingung in der Nähe von 840 cm⁻¹ verursacht wird, 0,03 bis 0,15 beträgt; und worin
das Verhältnis [I_{(N-H)}/I_{(Si-H)}] zwischen der Peakintensität I_{(N-H)} einer Absorption, die durch eine N-H-Streckschwindung in der Nähe von 3.350 cm⁻¹ in dem FT-IR-Absorptionsspektrum verursacht wird, und der Peakintensität I_{(Si-H)} 0,5 bis 1,5 beträgt, worin die Beschichtung auf einem Substrat vorliegt.

2. Gassperrbeschichtung gemäß Anspruch 1, worin
das Verhältnis [I_{(N-H)}/I_{(Si-N)}] zwischen der Peakintensität I_{(N-H)} einer Absorption, die durch eine N-H-Streckschwindung in der Nähe von 3.350 cm⁻¹ in dem FT-IR-Absorptionsspektrum verursacht wird, und der Peakintensität I_{(Si-N)} 0,03 bis 0,07 beträgt.

3. Gassperrbeschichtung gemäß Anspruch 1 oder 2, die eine Dichte von 2,1 bis 2,7 g/cm³ aufweist.

4. Gassperrbeschichtung gemäß irgendeinem der Ansprüche 1 bis 3, worin der Peak der Absorption, die durch die Si-N-Streckschwingung in der Nähe von 840 cm⁻¹ verursacht wird, in dem FT-IR-Absorptionsspektrum bei einer Wellenzahl im Bereich von 820 bis 860 cm⁻¹ auftritt.

5. Gassperrbeschichtung gemäß irgendeinem der Ansprüche 1 bis 4, worin die mittlere Si-N-Bindungslänge 1,69 bis 1,73 Å beträgt.

6. Gassperrbeschichtung gemäß irgendeinem der Ansprüche 1 bis 5, die einen Sauerstoffgehalt von nicht mehr als 15 Atom% aufweist.

7. Gassperrbeschichtung gemäß irgendeinem der Ansprüche 1 bis 6, die eine Dicke von 10 bis 150 nm aufweist.

8. Gassperrbeschichtung gemäß irgendeinem der Ansprüche 1 bis 7, die als Einzelschicht eine Durchlässigkeit für sichtbares Licht von nicht weniger als 95 % aufweist.

9. Gassperrfolie, umfassend:
eine Harzfolie mit einer Glasübergangstemperatur von 130°C oder niedriger; und
die Gassperrbeschichtung gemäß irgendeinem der Ansprüche 1 bis 9, abgeschieden auf der Harzfolie.

10. Gassperrfolie, umfassend:
eine Substratfolie; und
die Gassperrbeschichtung gemäß irgendeinem der Ansprüche 1 bis 9, abgeschieden auf der Substratfolie,
worin die Gassperrfolie Gassperreigenschaften aufweist, die eine Gaspermeation von höchstens 1 x 10⁻⁵ [g/(m²·Tag)] erlauben, und eine Durchlässigkeit für sichtbares Licht von nicht kleiner als 85 % aufweist, und
worin die Gassperreigenschaften und die Durchlässigkeit für sichtbares Licht beibehalten werden, sogar nachdem sie in einer Umgebung bei einer Temperatur von 60°C und einer relativen Luftfeuchtigkeit von 90 % für 1.000 Stunden belassen wurde, und auch beibehalten werden, nachdem sie 1.000 mal zu einer Rolle von 10 mm Durchmesser gewickelt und dann abgewickelt worden ist.

11. Gassperrfolie, umfassend:
eine Substratfolie; und
die Gassperrbeschichtung gemäß irgendeinem der Ansprüche 1 bis 9, abgeschieden auf der Substratfolie,
worin die Gassperrfolie Gassperreigenschaften aufweist, die eine Gaspermeation von höchstens 3 x 10⁻³ [g/(m²·Tag)] ermöglichen, und eine Durchlässigkeit für sichtbares Licht von nicht kleiner als 85 % aufweist, und
worin die Gassperreigenschaften und die Durchlässigkeit für sichtbares Licht beibehalten werden, sogar nachdem sie in einer Umgebung bei einer Temperatur von 60°C und einer relativen Luftfeuchtigkeit von 90 % für 1.000 Stunden belassen worden ist, und auch dann beibehalten werden, nachdem sie 1.000 mal zu einer Rolle von 10 mm Durchmesser gewickelt und dann abgewickelt worden ist.

## Revendications

1. Revêtement barrière aux gaz à base de nitrure de silicium ayant :
un rapport de composition N/Si de 1 à 1,4 et
une teneur en hydrogène de 10 à 30 pour cent atomique,
dans lequel :
un pic d'une absorption provoquée par une vibration d'étirage Si-H se produit à un nombre d'onde allant de 2 170 à 2 200 cm⁻¹ dans un spectre d'absorption d'infrarouge de transformée de Fourier du revêtement, avec
un rapport [I_{(Si-H)}/I_{(Si-N)}] entre une intensité de pic I_{(Si-H)} de l'absorption provoquée par une vibration d'étirage Si-H et une intensité de pic I_{(Si-N)} d'une absorption provoquée par une vibration d'étirage Si-N au voisinage de 840 cm⁻¹ qui est de 0,03 à 0,15 ; et dans lequel :
un rapport [I_{(N-H)}/I_{(Si-H)}] entre une intensité de pic I_{(N-H)} d'une absorption provoquée par une vibration d'étirage N-H au voisinage de 3 350 cm⁻¹ dans le spectre d'absorption d'infrarouge de transformée de Fourier et ladite intensité de pic I_{(Si-H)} est de 0,5 à 1,5, dans lequel le revêtement est appliqué sur un substrat.

2. Revêtement barrière aux gaz selon la revendication 1, dans lequel :
un rapport [I_{(N-H)}/I_{(Si-N)}] entre une intensité de pic I_{(N-H)} d'une absorption provoquée par une vibration d'étirage N-H au voisinage de 3 350 cm⁻¹ dans le spectre d'absorption d'infrarouge de transformée de Fourier et ladite intensité de pic I_{(Si-N)} est de 0,03 à 0,07.

3. Revêtement barrière aux gaz selon la revendication 1 ou 2, ayant une masse volumique de 2,1 à 2,7 g/cm³.

4. Revêtement barrière aux gaz selon l'une quelconque des revendications 1 à 3, dans lequel un pic de l'absorption provoquée par une vibration d'étirage Si-N au voisinage de 840 cm⁻¹ se produit à un nombre d'onde allant de 820 à 860 cm⁻¹ dans le spectre d'absorption d'infrarouge de transformée de Fourier.

5. Revêtement barrière aux gaz selon l'une quelconque des revendications 1 à 4, dans lequel une longueur de liaison Si-N moyenne est de 1,69 à 1,73 Å.

6. Revêtement barrière aux gaz selon l'une quelconque des revendications 1 à 5, ayant une teneur en oxygène de pas plus de 15 pour cent atomique.

7. Revêtement barrière aux gaz selon l'une quelconque des revendications 1 à 6, ayant une épaisseur de 10 à 150 nm.

8. Revêtement barrière aux gaz selon l'une quelconque des revendications 1 à 7, ayant un taux de transmission de lumière visible de pas moins de 95 % en simple couche.

9. Film barrière aux gaz comprenant :
un film de résine ayant une température de transition vitreuse de 130 °C ou moins ; et
le revêtement barrière aux gaz selon l'une quelconque des revendications 1 à 8 déposé sur le film de résine.

10. Film barrière aux gaz comprenant :
un film substrat ; et
le revêtement barrière aux gaz selon l'une quelconque des revendications 1 à 9 déposé sur le film substrat,
dans lequel le film barrière aux gaz a une propriété de barrière aux gaz permettant une perméation aux gaz au maximum de 1*10⁻⁵ [g/(m². jour)] et un taux de transmission de lumière visible de pas moins de 85 %, et
dans lequel la propriété de barrière aux gaz et le taux de transmission de lumière visible sont maintenus même après être laissés dans un environnement à une température de 60 °C et une humidité relative de 90 % pendant 1000 heures et même après être enroulés en un rouleau de 10 mm de diamètre, puis déroulés 1 000 fois, également.

11. Film barrière aux gaz comprenant :
un film substrat ; et
le revêtement barrière aux gaz selon l'une quelconque des revendications 1 à 9 déposé sur le film substrat,
dans lequel le film barrière aux gaz a une propriété de barrière aux gaz permettant une perméation aux gaz au maximum de 3*10⁻³ [g/(m². jour)], et un taux de transmission de lumière visible de pas moins de 85 %, et
dans lequel la propriété de barrière aux gaz et le taux de transmission de lumière visible sont maintenus même après être laissés dans un environnement à une température de 85 °C et une humidité relative de 90 % pendant 1 000 heures et même après être enroulés en un rouleau de 10 mm de diamètre, puis déroulés 1 000 fois, également.
